# FASCICULE DE BREVET EUROPEEN

(11) **EP 3 117 514 B1**
(45) Date de publication et mention de la délivrance du brevet: **18.11.2020**
(21) Numéro de dépôt: 15715336.2
(22) Date de dépôt: 11.03.2015
(51) Int. Cl.: H02N 2/18

(54) **DISPOSITIF PIEZOELECTRIQUE DE GENERATION DE TENSION ELECTRIQUE**
PIEZOELEKTRISCHE VORRICHTUNG ZUR STROMERZEUGUNG
PIEZOELECTRIC DEVICE FOR ELECTRIC POWER GENERATION

(30) Priorité: 13.03.2014 FR 1452071
(43) Date de publication de la demande: 18.01.2017
(73) Titulaire: HAGER-ELECTRO SAS, 67210 Obernai (FR)
(72) Inventeur: MARTIN, Jean-Frédéric, F-69680 Chassieu (FR); DIDIER, Sébastien, F-38460 Cremieu (FR)
(74) Mandataire: Cabinet Nuss
(86) Numéro de dépôt international: PCT/FR2015/050610
(87) Numéro de publication internationale: WO 2015/136224

(56) Documents cités:
- WO-A1-2010/007309
- DE-A1-102006 025 963
- US-A- 4 780 062
- US-A1- 2009 243 254

## Description

### Domaine technique

L'invention se rattache au domaine des dispositifs générateurs électriques, utilisant la conversion d'une énergie mécanique en énergie électrique par le biais d'éléments piézoélectriques. L'invention vise plus particulièrement une nouvelle architecture mécanique d'un tel dispositif, qui procure en particulier des avantages majeurs en termes de mise en oeuvre, de robustesse et de rendement.

### Techniques antérieures

De nombreux systèmes électriques embarquent leur propre générateur d'énergie électrique. Certains de ces générateurs sont conçus pour générer une énergie électrique en se basant notamment sur la conversion d'une énergie disponible à proximité de l'appareil.

On peut ainsi citer les dispositifs photovoltaïques qui convertissent une énergie lumineuse, ou encore les dispositifs à base d'éléments piézoélectriques qui permettent de convertir une énergie mécanique en une tension électrique consécutive à la déformation de l'élément piézoélectrique.

De nombreux dispositifs de génération d'énergie électrique par effet piézoélectrique ont déjà été proposés. De tels dispositifs intègrent généralement une lame vibrante plane, fixée par une de ses extrémités à un support fixe, et dont l'autre extrémité libre peut se déplacer sous l'effet d'une force mécanique qui lui est appliquée. En outre, un ou plusieurs éléments piézoélectriques sont généralement disposés sur les faces de la lame, et subissent donc des déformations en même temps que cette dernière oscille. Ces déformations provoquent l'apparition d'une tension électrique aux bornes de l'élément piézoélectrique. Cette tension peut ensuite être redressée pour charger un composant capacitif, du type condensateur, de manière à alimenter une charge. De tels dispositifs sont par exemple décrits dans les documents US 2005/0280561, EP 0 725 452, DE 296 14 851 U, ou bien encore US 7 005 778 et US4780062.

Un dispositif de ce type est d'ailleurs proposé par la Demanderesse dans le document WO2010/007309. Ce dispositif piézoélectrique est notamment constitué d'une lame pliée présentant un profil en U ou en V, fixée à un support fixe au niveau de la portion courbée de la lame au moyen d'excroissances ou de fentes latérales. Les deux extrémités de la lame sont ainsi libres d'osciller. Cependant, en fonction des conditions dans lesquelles le dispositif est mis en oeuvre, il est possible que la tenue mécanique des éléments participant à la fixation de la lame au support fixe se dégrade dans le temps. Les excroissances latérales sont notamment sensibles au vieillissement et aux contraintes mécaniques appliquées, et le maintien via les fentes latérales n'est pas assuré en cas de choc. Par ailleurs, l'augmentation de la surface de serrage au niveau de la portion courbe de la lame impliquerait une augmentation de l'amortissement et donc un mauvais transfert de l'énergie entre les deux branches de la lame. En outre, la fixation d'éléments piézoélectriques sur les surfaces principales internes de cette lame préalablement courbée est rendue complexe.

Dans une autre variante présentée dans le document WO2008/099122 de la Demanderesse, le dispositif piézoélectrique est également constitué d'une lame pliée présentant un profil en U ou en V, présentant une extrémité libre apte à osciller sous l'effet d'une force mécanique et une extrémité fixée à un support fixe au moyen d'élément mécanique. Cette configuration permet notamment à la zone de pli de jouer le rôle de ressort en se déformant de manière privilégiée pour limiter les contraintes mécaniques au niveau du point d'accrochage de la lame sur le support fixe. Cette configuration est particulièrement bien adaptée lorsque l'excitation de la lame est assurée par la vibration du support, mais inadéquate dans le cas d'une excitation induite par l'application d'une force impulsionnelle sur l'extrémité libre de la lame. En effet, dans ce dernier cas, une grande partie de l'énergie mécanique générée lors de l'excitation de la lame est transmise au support, donc perdue.

### Exposé de l'invention

Dans ce contexte, la présente invention a ainsi pour but de proposer un générateur piézoélectrique à base de lame oscillante exempt des limitations précédemment évoquées. La présente invention vise à proposer un générateur piézoélectrique performant, moins encombrant, facile à positionner, avec un maintien mécanique efficace et durable dans le temps.

L'invention concerne donc un dispositif piézoélectrique de génération de tension électrique selon la revendication indépendante de dispositif 1.

Conformément à l'invention, le dispositif piézoélectrique comprend en outre une deuxième lame de structure identique à celle de la première lame, les premières branches des première et deuxième lames étant solidarisées entre elles et étant fixes l'une par rapport à l'autre.

En d'autres termes, le dispositif de l'invention est formé de deux lames courbes de forme similaire, simplifiant ainsi la fabrication du dispositif. Chaque lame originellement plane et droite, est pliée de façon à former une portion courbe contenant une zone de pliure transversale. Ainsi, chacune des lames présente une portion courbe délimitant une première branche et une deuxième branche de la lame, la première branche étant destinée à être solidarisée à un support fixe, et la deuxième branche présente une extrémité libre apte à osciller autour de sa position de repos sous l'effet d'une force mécanique qui lui est appliquée.

En outre, les deux lames sont solidarisées entre elles de sorte que les premières branches restent immobiles, même lorsque les extrémités libres des deuxième branches sont en oscillation. En particulier, les premières branches des première et deuxième lames sont de préférence solidarisées entre elles sur tout ou partie de leur surface et sont fixes l'une par rapport à l'autre. Différents moyens de solidarisation entre les premières branches peuvent être envisagés. En pratique, cette solidarisation peut être telle que, lors de la mise en oscillation des extrémités libres, les premières branches peuvent être comprimées ou écartées, mais les contraintes présentes au niveau des premières branches et qui sont perpendiculaires aux surfaces principales de ces premières branches, s'annulent mutuellement, pour assurer l'immobilisation des premières branches.

On comprend que l'absence de déplacement des premières branches lors de l'excitation des lames, permet de limiter le transfert, et donc la perte, de l'énergie mécanique des lames vers le support. Pour chacune des lames, toute l'énergie cinétique générée lors de l'oscillation est donc emmagasinée temporairement dans la portion courbe.

Ce résultat ne peut être obtenu par la solution préconisée dans la demande WO2008/099122. En effet, la structure de la solution de l'art antérieur est adaptée pour transmettre un maximum d'énergie du support vers la lame. De ce fait, on comprend bien que si la lame de cet art antérieur est utilisée en mode impulsionnel, une grande quantité d'énergie serait transférée vers le support, et donc perdue.

On comprend en outre que la solidarisation des premières branches visant à interdire tout déplacement mécanique notable de ces premières branches, permet non seulement de limiter toute perte d'énergie des lames vers le support, mais permet également de réduire l'encombrement du dispositif en vue de son encastrement dans un boîtier.

La solution de l'invention répond donc à un problème unique à savoir la réduction de l'encombrement combinée avec l'amélioration du rendement énergétique.

En général, plus le rayon de courbure de la portion courbe est petit et fermé, plus la portion courbe restitue de l'énergie, contribuant ainsi à diminuer l'amortissement de la lame. Par exemple, les deuxièmes branches peuvent former entre elles un angle (α) inférieur ou égal à 30° en l'absence d'oscillation.

En pratique, les deux lames sont de préférence disposées symétriquement par rapport à un plan sensiblement parallèle aux surfaces principales de la première branche d'une des lames.

Selon un mode de réalisation, chacune des première et deuxième lames présente une face principale interne et une face principale externe opposée à ladite face principale interne, les faces principales internes des premières branches de la première lame et de la deuxième lame étant en regard l'une de l'autre, et étant solidarisées entre elles sur tout ou partie de leur surface.

En d'autres termes, dans cette variante, l'une des faces principales de la première lame est en regard de l'une des faces principales de la deuxième lame, et les portions des faces principales qui sont en regard et qui sont délimitées par les premières branches sont solidarisées entre elles sur tout ou partie de leur surface. Les deux lames forment ainsi une structure présentant un profil en Y.

Selon un autre mode de réalisation, chacune des première et deuxième lames présente une face principale interne et une face principale externe opposées à ladite face principale interne. En outre, pour chacune des première et deuxième lames, la portion de la face interne délimitée par la première branche est en regard de la portion de la face interne délimitée par la deuxième branche. Par ailleurs, les portions des faces externes délimitées par les premières branches sont solidarisées entre elles sur tout ou partie de leur surface. En d'autres termes, dans cette autre variante, les deux lames forment une structure présentant un profil en E.

L'encombrement du dispositif est ainsi réduit puisque l'encastrement du dispositif est réalisé dans l'espacement situé entre les deuxièmes branches des lames. En pratique, pour chacune des lames, la première branche présente de préférence des dimensions longitudinale et/ou transversale plus petites que celles de la deuxième branche, afin d'éviter tout risque de contact des extrémités libres des deuxièmes portions avec les premières branches lors des oscillations.

Selon une variante de ces modes de réalisations, les premières branches peuvent être sensiblement planes, et peuvent être fixées l'une à l'autre sur toute leur surface. Les deux premières branches sont mises en contact direct.

En pratique, la solidarisation des premières branches entre-elles peut être obtenue par différents moyens adaptés tels que collage, soudure, serrage par pincement ou par vissage, etc...

Selon l'invention, les premières branches sont munies d'un ou de plusieurs évidements. Chacun de ces évidements est notamment apte à coopérer avec des moyens de fixation adaptés pour fixer les premières branches entre elles et/ou solidariser les premières branches au support fixe. Les premières branches peuvent ainsi être munies d'orifices ou d'encoches destinés à coopérer avec des vis.

Avantageusement, la première branche de chacune des lames s'étend de la portion courbe avec un rétrécissement transversal. Ce rétrécissement transversal peut être partiel, c'est-à-dire sur une portion de la longueur de la branche, ou totale, c'est-à-dire sur toute la longueur de la branche. En d'autres termes, indépendamment des évidements définis ci-dessus, l'extrémité de la première branche qui est fixée à la portion courbe présente une échancrure, de sorte que la dimension transversale, à savoir la largeur, de la première branche est globalement inférieure ou égale à celle de la deuxième branche. Cette solution permet notamment de fixer le dispositif piézoélectrique sur un support fixe sans augmenter la dimension transversale globale du dispositif piézoélectrique. Par exemple, le dispositif piézoélectrique peut être fixé au support fixe par l'intermédiaire d'une pièce extérieure ou d'une empreinte réalisée sur le support et qui présente une géométrie inverse de celle de l'échancrure.

Avantageusement, la dimension transversale de la première branche peut être supérieure, sur tout ou partie de sa longueur, à celle de la deuxième branche. Dans ce cas, il est préférable que la dimension longitudinale de la première branche soit inférieure ou égale à celle de la deuxième branche. En d'autres termes, la première branche peut être pourvue d'excroissances s'étendant transversalement. Ces excroissances peuvent être munies d'évidements tels que décrit ci-dessus.

Cet agencement permet notamment d'avoir une première branche plus importante non soumise à déformation lors des oscillations de la deuxième branche. Il est donc possible d'avoir une surface de contact plus importante destinée au positionnement et au maintien des lames sur un support fixe, et d'utiliser des moyens de fixation de la lame au support fixe moins encombrants. Grâce cet agencement, le dispositif piézoélectrique est plus compact et le risque de contact inapproprié entre les lames lors de fortes oscillation est minimisé. En outre, l'encastrement du dispositif est rendu plus aisé et le maintien est plus robuste.

Ainsi, de manière générale, pour chacune des première et deuxième lames, la dimension transversale de la première branche peut être différente de celle de la deuxième branche.

Selon une autre variante de ces modes de réalisations, il est possible de mettre en œuvre un entrelacement des premières branches entre elles de sorte qu'elles assurent mutuellement leur blocage lorsque les lames sont en oscillation. Plus précisément, les premières branches peuvent être conformées pour autoriser un entrelacement de tout ou partie des premières branches entre elles.

En pratique, l'entrelacement peut être tel que les premières branches sont en contact entre elles au niveau de trois zones, à savoir :
- une première zone proche de la portion courbe ;
- une deuxième zone située au croisement médian des premières branches ;
- une troisième zone proche de l'extrémité libre des premières branches.

Par exemple, selon une variante, chaque première branche peut être munie d'au moins une fente à travers laquelle passe une portion de l'autre branche. En particulier, chacune des premières branches peut être formée d'une partie centrale reliant une partie proximale et une partie distale, la partie centrale présentant des dimensions transversales inférieures à celles des parties distale et proximale. Dans cette variante, l'entrelacement peut être tel que les faces externes délimitées par les parties proximales sont en regard et que les faces internes des parties distales sont en regard.

Avantageusement, chacune des deuxièmes branches présente au moins une saillie qui peut s'étendre latéralement et/ou longitudinalement de leur extrémité libre, ladite saillie étant apte à coopérer avec un mécanisme extérieur destinée à l'application d'une contrainte mécanique sur ladite extrémité libre. Le mécanisme extérieur est notamment conformé pour assurer l'application d'une force impulsionnelle sur l'extrémité libre des lames, c'est-à-dire à l'application d'une contrainte de force et d'amplitude prédéterminées et au relâchement instantanée des lames. En pratique, les saillies peuvent être obtenues par usinage de la lame ou par l'ajout d'une pièce adaptée à l'extrémité de la lame.

Par ailleurs, chacune des lames peut comprendre un ou plusieurs éléments piézoélectriques disposés sur l'une des faces principales ou sur les deux faces principales de la deuxième branche. En d'autres termes, pour chacune des lames, des éléments piézoélectriques peuvent être disposés sur la face interne et/ou externe de la deuxième branche.

En pratique, les éléments piézoélectriques sont de préférence déposés au plus près de la portion courbe.

Par exemple, l'élément piézoélectrique peut être disposé dans une zone s'étendant de la portion courbe jusqu'à un point situé à une distance comprise entre 20 et 70 % de la longueur de la deuxième branche.

L'agencement ainsi proposé permet d'offrir un dispositif piézoélectrique ayant un facteur de qualité mécanique élevé, ainsi qu'un couplage mécanique supérieur par rapport aux solutions de l'art antérieur. Par ailleurs, le transfert d'énergie au point d'encastrement est minimisé, et les solutions de fixation sont plus robustes et plus fiables dans le temps. En outre, la réalisation de ces lames ne nécessite pas un procédé de fabrication complexe.

### Brève description des dessins

D'autres caractéristiques et avantages de l'invention ressortiront clairement de la description qui en est faite ci-après, à titre indicatif et nullement limitatif, en référence aux figures annexées, dans lesquelles :
- la figure 1 est une vue en perspective sommaire du dispositif selon un mode de réalisation de l'invention ;
- la figure 2 est une vue de profil du dispositif de la figure 1 ;
- la figure 3 est une vue en perspective sommaire d'une des lames du dispositif selon un autre mode de réalisation ;
- la figure 4 est une vue en perspective sommaire du dispositif intégrant deux lames de la figure 3 ;
- la figure 5 est une vue de profil du dispositif de la figure 4 ;
- les figures 6 à 9 sont des vues en perspective sommaire du dispositif selon différentes variantes de l'invention concernant la façon de solidariser les lames au support ;
- la figure 10 est une vue en perspective sommaire du dispositif selon une autre variante de l'invention concernant le maintien des lames entre elles ;
- la figure 11 est une vue en coupe selon le plan XZ du dispositif de la figure 10 ;
- les figures 12 et 13 sont des vues en perspective sommaire du dispositif selon une autre variante de l'invention concernant le maintien des lames entre elles ; et
- les figures 14 à 18 sont des vues en perspective sommaire du dispositif selon d'autres variantes de l'invention dans lesquelles les extrémités libres des lames présentent des formes particulières.

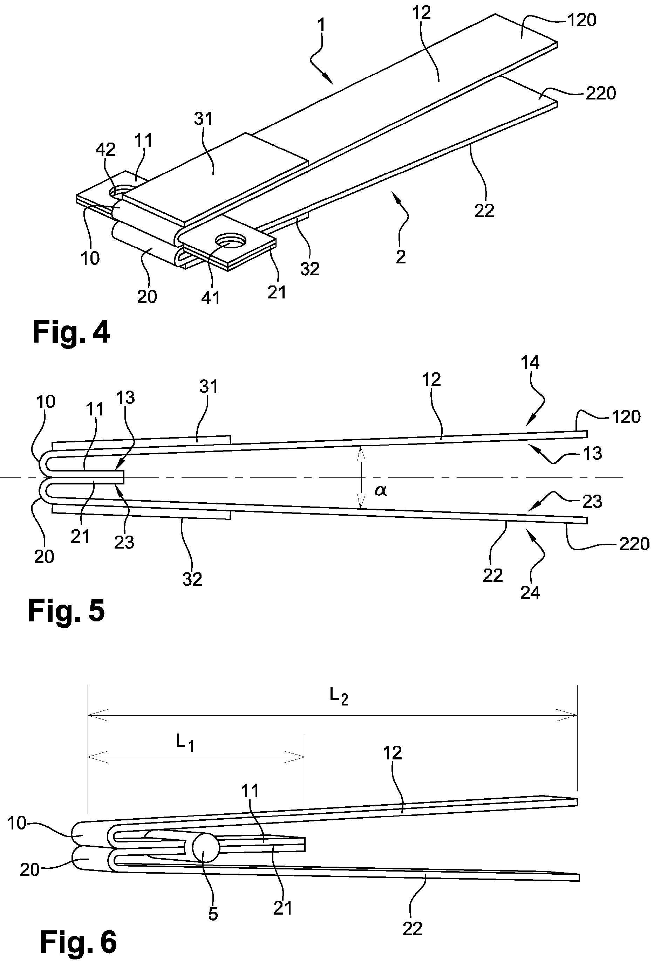

Les variantes présentées dans les figures 6, 8-13, 18 sont en dehors de l'invention revendiquée.

### Exposé détaillé de certains modes de réalisation particulier

Différentes variantes du dispositif mécanique de l'invention sont présentées ci-après. Les dispositifs mécaniques présentés ci-après comprennent tous deux lames de forme sensiblement identique à base d'un matériau rigide.

Chaque lame originellement plane et droite, présente donc une face principale interne et une face principale externe opposée à la face principale interne. La lame est pliée de façon à présenter une portion courbe contenant une zone de pliure transversale. Cette portion courbe délimite ainsi des première et deuxième branches de la lame. La première branche est destinée à être solidarisée à un support fixe et la deuxième branche présente une extrémité libre apte à osciller. Par ailleurs, un ou plusieurs éléments piézoélectriques peuvent être déposés sur les faces principales de la deuxième branche. Les deux lames sont disposées à l'aplomb l'une de l'autre, par exemple symétriquement par rapport au plan contenant l'une des faces principales de la première branche d'une des lames. En outre, ces deux lames sont solidarisées entre elles au niveau de leur première branche, et les deuxièmes branches forment de préférence entre elles un angle inférieur ou égal à 30° en l'absence d'oscillation.

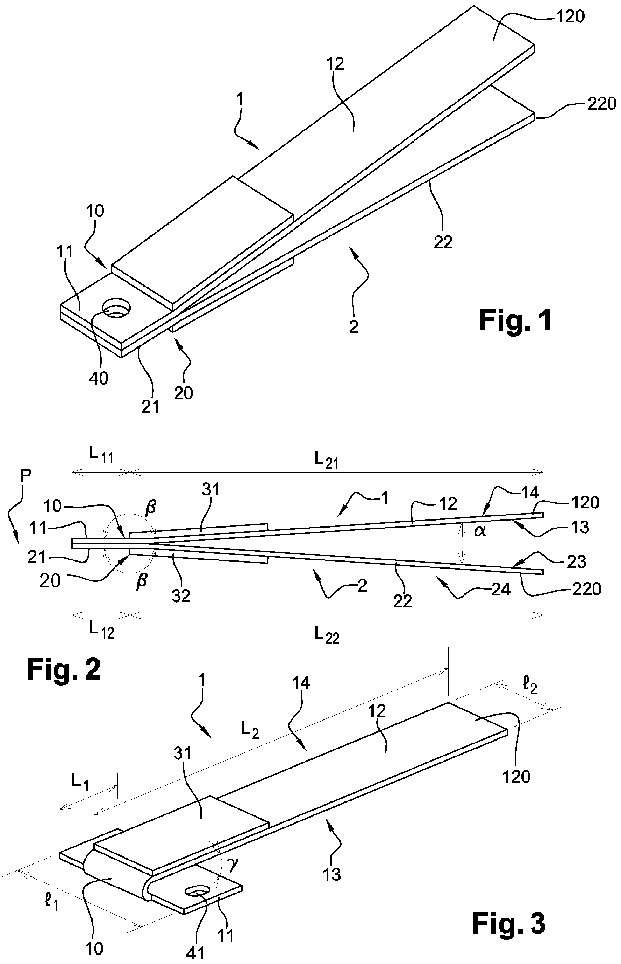

Dans le mode de réalisation illustré aux figures 1 et 2, on retrouve donc les deux lames courbées **1, 2,** présentant chacune deux faces principales opposées, à savoir la face principale interne **13, 23** et la face principale externe **14, 24.** Chacune des lames **1, 2** courbées est donc formée de la portion courbe **10, 20** contenant la zone de pliure transversale reliant la première branche **11, 21** fixe et la deuxième branche **12, 22** portant l'extrémité libre **120, 220.** Dans ce mode de réalisation, pour chacune des lames **1, 2,** le rayon de courbure de la portion courbe est de préférence au moins égale à l'épaisseur de la lame, par exemple égal à 0,8mm. En d'autres termes, l'angle obtus β formé entre la première branche **11, 21** avec la deuxième branche **12, 22** est de préférence compris entre 160° et 179°, par exemple 176°. Par ailleurs, les première et deuxième branches sont sensiblement droites et planes. Le ratio entre la longueur **L11**, **L12** de la première branche **11, 21** et la longueur **L21, L22** de la deuxième branche **12, 22** est de préférence compris entre 10 et 120%, par exemple 25%.

Bien entendu, la forme et les dimensions de la première branche s'adaptent en fonction du besoin d'encastrement et d'encombrement du dispositif.

Chacune des lames porte sur leur face principale externe **14, 24** un élément piézoélectrique **31, 32.**

Les deux lames sont disposées à l'aplomb l'une de l'autre, et les deux lames **1, 2** sont solidarisées l'une à l'autre au niveau des premières branches **11, 21,** formant ainsi une structure avec un profil en Y. Les deux lames sont donc agencées symétriquement par rapport à un plan **P** parallèle aux premières branches, et les faces principales internes **13, 23** des deux lames **1, 2** sont positionnées en regard l'une de l'autre.

Dans ce mode de réalisation, les premières branches **11, 21** sont rendues fixes l'une par rapport à l'autre, par exemple par collage ou soudage des premières branches **11, 21** entre elles. Comme illustré sur la figure 1, il est également possible de prévoir un orifice **40** traversant les premières branches **11, 21,** apte à coopérer avec une vis ou tout autre moyen adapté pour assurer la solidarisation des premières branches **11, 21** entre elles. Par ailleurs, cette vis peut également servir à assurer la fixation des lames **1, 2** au support fixe (non illustré).

On comprend donc que l'application d'une force notamment sur l'extrémité libre de chacune des lames permet sa mise en oscillation et donc la génération d'une énergie électrique par l'élément piézoélectrique.

Cet agencement offre une structure compacte et robuste comprenant deux lames aptes à osciller. Cet agencement présente plusieurs avantages tels qu'un processus de collage des éléments piézoélectriques sur les lames plus simple, et un processus de fabrication du dispositif également plus simple puisqu'il suffit de fabriquer deux lames identiques et de les assembler.

Dans un autre mode de réalisation illustré aux figures 3 à 11, la structure se présente maintenant sous la forme d'un E. On retrouve donc encore ici les deux lames courbées **1, 2,** qui présentent chacune deux faces principales opposées à savoir la face principale interne **13, 23** et la face principale externe **14, 24.** Chacune des lames **1, 2** courbées est donc formée de la portion courbe **10, 20** contenant la zone de pliure transversale reliant la première branche **11, 21** fixe et la deuxième branche **12, 22** portant l'extrémité libre **120, 220.** De préférence, le rayon de courbure de la portion courbe **10, 20** est au minimum égale à l'épaisseur de la lame, par exemple égal à 0,6mm. En d'autres termes, l'angle aigu y formé entre la première branche **11, 21** avec la deuxième branche **12, 22** est de préférence compris entre -5 et 20 °, par exemple égal à 6°. Ainsi, dans ce mode de réalisation, le rayon de courbure de la portion courbe **10, 20** est tel que la face principale interne **13, 23** de la première branche **11, 21** est en regard de la face principale interne **13, 23** de la deuxième branche **12, 22.**

Les première et deuxième branches sont également sensiblement droites et planes, et des éléments piézoélectriques **31, 32** sont déposés sur les faces principales externes **14, 24** des lames au niveau des deuxièmes branches.

Les deux lames **1, 2** sont disposées à l'aplomb l'une de l'autre, et sont notamment agencées symétriquement par rapport à un plan **P** parallèle aux premières portions **11, 21.**

Les deux lames **1, 2** sont solidarisées l'une à l'autre au niveau des premières branches **11, 21,** formant ainsi une structure avec un profil en E. Les premières branches **11, 21** sont notamment rendues fixes l'une par rapport à l'autre par tous moyens adaptés, par exemple par collage ou soudage des premières branches **11, 21** entre elles.

Dans la variante illustrée sur les figures 3 et 5, les première et deuxième branches de chaque lame présentent des dimensions différentes. En particulier, pour chaque lame, la deuxième branche **12, 22** s'étend de préférence longitudinalement et la première branche **11, 21** s'étend de préférence transversalement et perpendiculairement à la deuxième branche. Par exemple, comme indiqué sur la figure 3, les dimensions longitudinales des première et deuxième branches peuvent être telles que **L1** est comprise entre 10 et 120% de **L2.** Les dimensions transversales des première et deuxième branches **11** et **12** s'adaptent en fonction de l'encombrement souhaité.

Dans cette variante, la fixation des premières branches entre-elles peut être assurée par des orifices **41, 42** traversant les premières portions **11, 21,** et coopérant avec des vis. Par ailleurs, l'ensemble orifices et vis peut également servir à assurer la fixation des lames **1, 2** au support fixe (non illustré).

Dans une autre variante illustrée à la figure 6, pour chaque lame, les première et deuxième branches **11, 21, 12, 22** s'étendent de préférence longitudinalement, avec comme particularité une première branche plus courte que la deuxième branche. En outre, comme illustré sur cette figure 6, les premières branches des lames peuvent être maintenues fixes l'une par rapport à l'autre au moyen d'au moins une pièce rapportée **5** de type pince, goupille fendue, murets liés au support, etc.

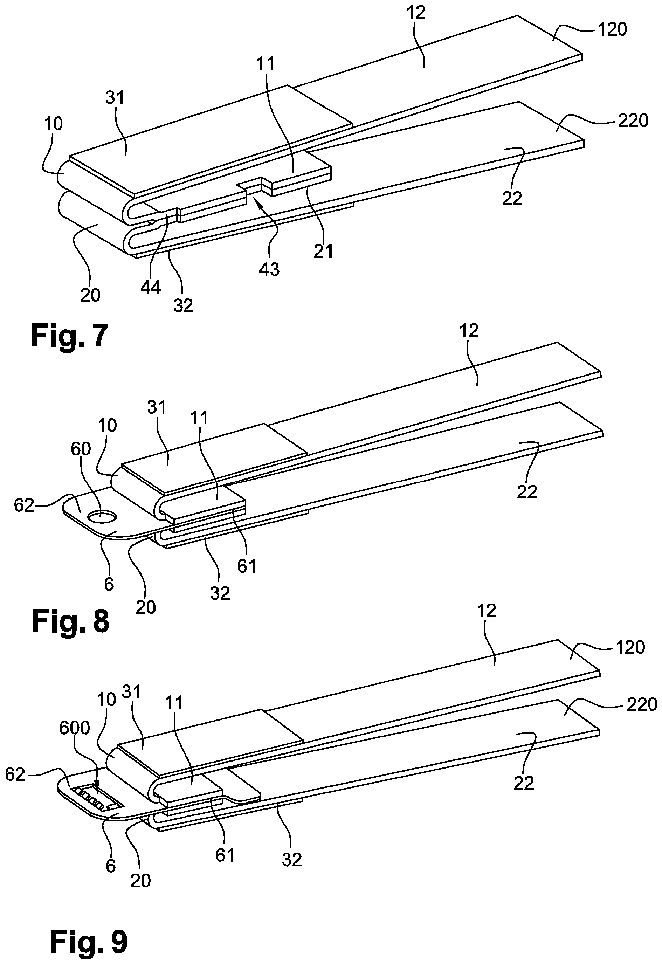

Dans une autre variante illustrée à la figure 7, il est possible de prévoir des évidements latéraux **43** réalisés dans les premières branches. Ces évidements latéraux **43** peuvent notamment coopérer avec d'autres pièces mécaniques pour maintenir les premières branches immobiles entre elles et solidariser les lames au support fixe. En outre, la première branche de chacune des lames peut s'étendre de la portion courbe avec un rétrécissement transversal. Ainsi, l'extrémité de la première branche qui est fixée à la portion courbe présente une échancrure **44,** de sorte que la dimension transversale de la première branche est globalement inférieure ou égale à celle de la deuxième branche.

Selon une autre variante illustrée aux figures 8 et 9, les premières branches peuvent être solidarisées au support fixe par l'intermédiaire d'une pièce rapportée **6,** par exemple sous forme d'une patte, disposée en sandwich entre les premières portions **11, 21.** Cette pièce rapportée **6** est de préférence à base d'un matériau métallique, et présente une première partie **61** en contact direct avec les premières branches **11, 21** des lames **1, 2** et une deuxième partie **62** destinée à être solidarisée au support fixe. La première partie peut notamment être solidarisée aux premières branches par collage, soudure, rivetage ou par tout moyen adapté. La deuxième partie **62** peut notamment être pourvue d'un trou **60** traversant apte à coopérer avec une vis pour la solidarisation au support (figure 8) ou peut être pourvue d'une ouverture **600** (figure 9) dont les bords présentent un relief permettant d'accrocher la pièce rapportée **6** au support.

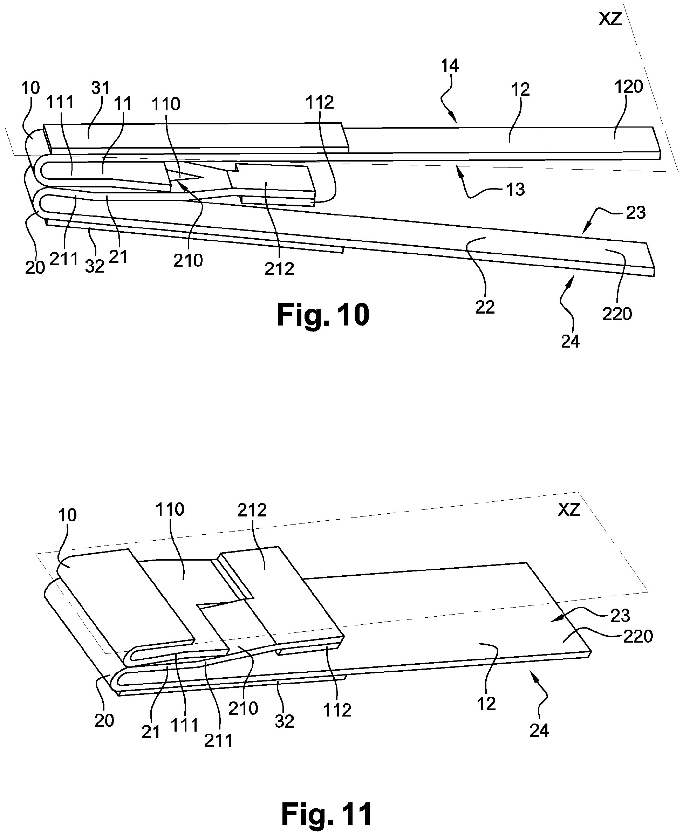

Selon une autre variante illustrée aux figures 10 et 11, les premières branches sont rendues fixes l'une par rapport à l'autre par un entrelacement des premières branches. Plus précisément, on réalise une fente large, ou un décochement, dans chacune des premières branches de sorte chacune des première branches présente longitudinalement une partie centrale **110, 210** reliant une partie proximale 111, **211** à une partie distale **112, 212.** L'entrelacement est obtenu en rapprochant les parties centrales amincies **110, 210** au niveau des fentes, de sorte que les faces externes **14, 24** des parties proximales **111, 211** se retrouvent en regard, et que les faces internes **13, 23** des parties distales **112, 212** reposent l'une sur l'autre. Un troisième contact entre les premières branches résulte du rapprochement des parties centrales, ce troisième contact étant situé à proximité des portions courbes **10, 20.**

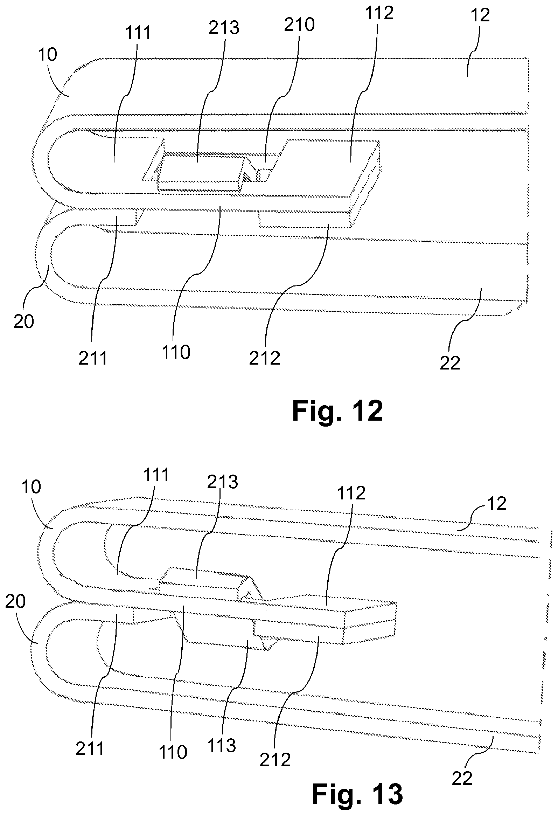

Selon une autre variante illustrée sur la figure 12 et 13, le blocage mutuel des premières branches est obtenu par l'entrelacement des parties centrales **113, 213** des premières branches. Dans ce cas de figure, chacune des parties centrales **113, 213** peut être délimitée par deux entailles, et présente de préférence des dimensions transversales sensiblement identiques à celles des partie proximales **111, 211** et distales **112, 212.** Dans cette variante, l'entrelacement peut être obtenu par la mise en regard des faces externes délimitées par les parties proximales et distales, et par la mise en regard des faces internes délimitées par les parties centrales.

En pratique, les dimensionnements et le positionnement des divers éléments peuvent être optimisés pour assurer un rendement maximum. La longueur et largeur de la deuxième branche permettent de définir une force d'actionnement et une quantité d'énergie récupérable par le générateur.

Par ailleurs, le positionnement de l'élément piézoélectrique sur la lame joue également un rôle dans le niveau de performance atteint. Ainsi, on a observé qu'il est avantageux que l'élément piézoélectrique soit implanté dans une région qui est située le plus proche de la portion courbe. Cette région de position optimale s'étend donc entre d'une part la jonction de la deuxième portion avec la portion courbe, et d'autre part, un second point distant du premier point d'une longueur comprise entre 20 et 60 % de la longueur de la deuxième portion. La longueur de l'élément piézoélectrique peut représenter entre 20 et 60 % de la longueur de la deuxième portion. Bien entendu, il est possible de disposer plusieurs éléments piézoélectriques en série ou en parallèle sur la lame.

Selon un mode de réalisation particulier, la deuxième branche de chacune des lames peut présenter une forme particulière adaptée à un mécanisme extérieur (non représenté) destiné à la mise en oscillation des lames par application d'une force impulsionnelle sur l'extrémité des lames.

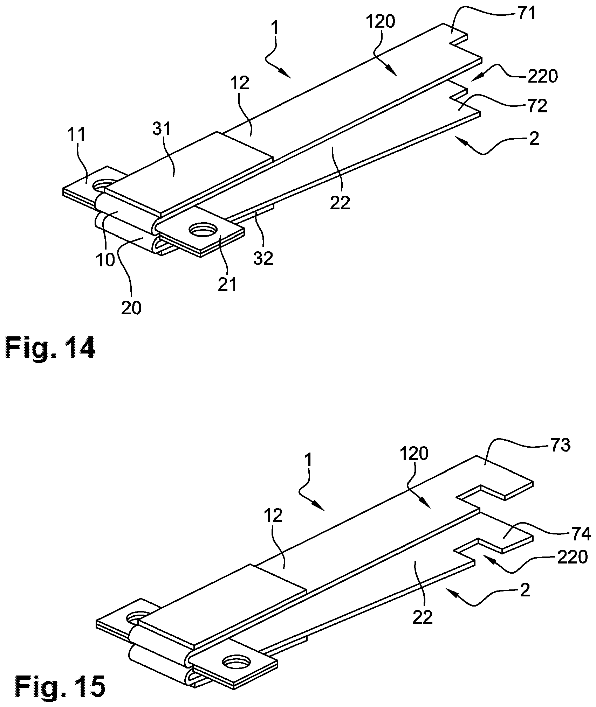

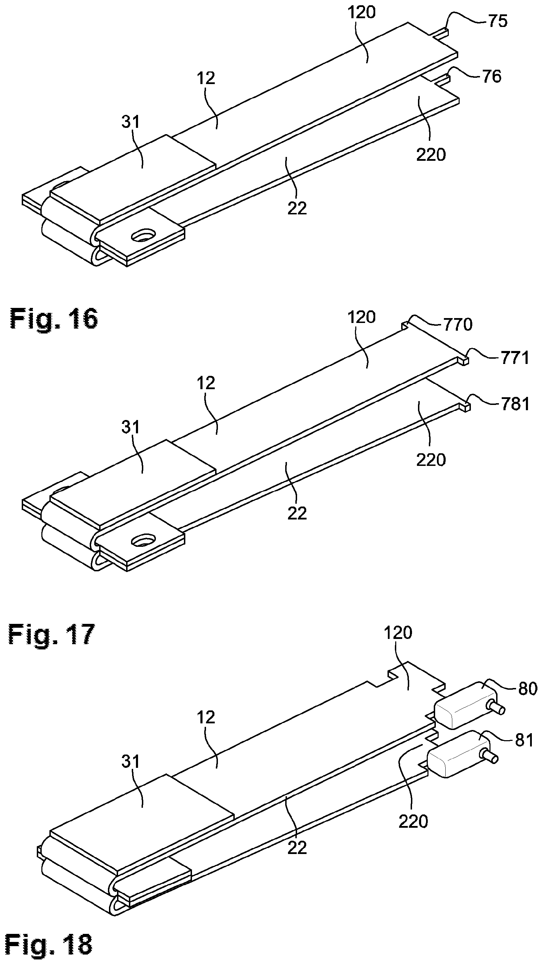

Par exemple, il est possible de prévoir sur chacune des deuxièmes branches **12, 22,** une ou plusieurs saillies **71, 72, 73, 74, 75, 76, 770, 771, 780** (figures 14 à 18), qui peuvent par exemple s'étendre longitudinalement (figures 14 à 16) ou transversalement (figure 17) de les extrémités libres **120, 220.** Chacune des saillies est notamment destinée à coopérer avec un mécanisme extérieur pour l'application d'une impulsion sur les extrémités libres correspondantes. Bien entendu, chacune des saillies peut également être obtenue par la disposition d'autre pièce additionnelle **80, 81** adaptée pour être fixée sur l'extrémité libre correspondante **120, 220** (figure 18).

Le dispositif présenté ci-dessus peut être utilisé de manière très large comme source d'alimentation en énergie électrique en remplacement d'accumulateurs, de piles, pour des applications de réseaux de capteurs sans fil ou pour toute application nécessitant une source d'énergie autonome, en bénéficiant d'une longue durée de vie.

On peut notamment citer les applications à des appareils de mesure des paramètres physiques dans des industries de procédé du type pétrochimie ou pharmacie. On peut mentionner les applications particulières à des capteurs de température, de pression ou de débit, et en particulier dans les circuits de distribution d'eau ou de gaz. Le dispositif présenté est notamment bien adapté pour être mis en œuvre dans des appareils de type interrupteurs électriques, sonnettes sans fil ou dispositifs de détection d'ouverture. Dans des versions miniaturisées, l'invention peut également être employée pour l'alimentation des systèmes micro-électro-mécaniques (MEMS).

## Revendications

1. Dispositif piézoélectrique de génération de tension électrique comprenant au moins une première lame (1) présentant une portion courbe (10) délimitant une première branche (11) et une deuxième branche (12) de la lame, la première branche (11) étant destinée à être solidarisée à un support fixe, la deuxième branche (12) étant sensiblement plane et ayant une extrémité libre (120) apte à osciller autour de sa position de repos sous l'effet d'une force mécanique, au moins un élément piézoélectrique (31) reposant sur une des faces principales (14) de la deuxième branche (12) de la première lame, et comportant une deuxième lame (2) de structure identique à la première lame (1), tout ou partie de la surface de l'une des faces principales de la première branche (11) de la première lame (1) étant solidarisée à tout ou partie de la surface de l'une des faces principales de la première branche (21) de la deuxième lame (2), et les premières branches étant fixes l'une par rapport à l'autre, **caractérisé en ce que** les première branches (11, 21) sont en contact direct et **en ce que** chacune des premières branches (11, 21) présente au moins un évidement (40, 41, 42, 43) apte au moins à coopérer avec des moyens de fixation des première branches (11, 21) au support fixe.

2. Dispositif selon la revendication I, ***caractérisé* en ce que** chacune des premières et deuxièmes lames (1, 2) présente une face principale interne (13, 23) et une face principale externe (14, 24) opposée à ladite face principale interne, les faces principales internes des première branches (11, 21) de la première lame (1) et de la deuxième lame (2) étant en regard l'une de l'autre, et étant solidarisées entre elles sur tout ou partie de leur surface.

3. Dispositif selon la revendication 1, ***caractérisé* en ce que** chacune des première et deuxième lames (1, 2) présente une face principale interne (13, 23) et une face principale externe (14, 24) opposées à ladite face principale interne, et **en ce que** pour chacune des première et deuxième lames (1, 2), la portion de la face interne (13, 23) délimitée par la première branche (11, 21) est en regard de la portion de la face interne (13, 23) délimitée par la deuxième branche (12, 22), les portions des faces externes délimitées par les premières branches étant solidarisées entre elles sur tout ou partie de leur surface.

4. Dispositif selon l'une des revendications 1 à 3, ***caractérisé* en ce que** pour chacune des première et deuxième lames (1, 2), la dimension transversale de la première branche (11, 21) est différente de celle de la deuxième branche (21, 22).

5. Dispositif selon l'une des revendications 1 à 3, ***caractérisé* en ce que** le blocage mutuel des premières branches (11, 21) est assuré par un entrelacement de tout ou partie des premières branches entre elles.

6. Dispositif selon la revendication 5, ***caractérisé* en ce que** chacune des premières branches est formée d'une partie centrale (110, 210) reliant une partie proximale (111, 211) et une partie distale (112, 212), la partie centrale présentant des dimensions transversales inférieures à celles des parties distale et proximale, tes faces externes délimitées par les parties proximales étant en regard et les faces internes des parties distales étant en regard.

7. Dispositif selon la revendication 5, ***caractérisé* en ce que** chacune des premières branches est formée d'une partie centrale (110, 210) reliant une partie proximale (111, 211) et une partie distale (112, 212), la partie centrale étant de dimension transversale sensiblement identique à celles des parties distales et proximales, les faces externes délimitées par les parties proximales et distales étant en regard, et les faces internes délimitées par les parties centrales étant en regard.

8. Dispositif selon l'une des revendications 1 à 6, ***caractérisé* en ce que** chacune des deuxièmes branches présente au moins une saillie (71, 72, 73, 74, 75, 76, 770, 771, 781) apte à coopérer avec un mécanisme extérieur pour l'application d'un contrainte mécanique sur les lames.

## Patentansprüche

1. Piezoelektrische Vorrichtung zur Erzeugung elektrischer Spannung umfassend mindestens ein erstes Blatt (1), das einen gekrümmten Abschnitt (10) aufweist, der einen ersten Schenkel (11) und einen zweiten Schenkel (12) des Blatts begrenzt, wobei der erste Schenkel (11) dazu bestimmt ist, mit einem festen Träger fest verbunden zu sein, der zweite Schenkel (12) im Wesentlichen eben ist und ein freies Ende (120) aufweist, das geeignet ist, unter der Wirkung einer mechanischen Kraft um dessen Ruheposition zu schwingen, wobei mindestens ein piezoelektrisches Element (31) auf einer der Hauptseiten (14) des zweiten Schenkels (12) des ersten Blatts ruht, und aufweisend ein zweites Blatt (2) mit einer Struktur, die mit dem ersten Blatt (1) identisch ist, wobei die gesamte oder ein Teilbereich der Fläche einer der Hauptseiten des ersten Schenkels (11) des ersten Blatts (1) mit der gesamten oder einem Teilbereich der Fläche einer der Hauptseiten des ersten Schenkels (21) des zweiten Blatts (2) fest verbunden ist und die ersten Schenkel zueinander fest sind, **dadurch gekennzeichnet, dass** die ersten Schenkel (11, 21) in direktem Kontakt stehen, und dadurch, dass jeder der ersten Schenkel (11, 21) mindestens ein Ausnehmung (40, 41, 42, 43) aufweist, die zumindest geeignet ist, mit Mitteln zum Befestigen der ersten Schenkel (11, 21) an dem festen Träger zusammenzuwirken.

2. Vorrichtung nach Anspruch 1, **dadurch gekennzeichnet, dass** jedes des ersten und zweiten Blatts (1, 2) eine Hauptinnenseite (13, 23) und eine Hauptaußenseite (14, 24), die der Hauptinnenseite gegenüberliegt, aufweist, wobei die Hauptinnenseiten der ersten Schenkel (11, 21) des ersten Blatts (1) und des zweiten Blatts (2) einander gegenüberliegen und über der gesamten oder einem Teilbereich ihrer Fläche fest miteinander verbunden sind.

3. Vorrichtung nach Anspruch 1, **dadurch gekennzeichnet, dass** jeder des ersten und zweiten Schenkels (1, 2) eine Hauptinnenseite (13, 23) und eine Hauptaußenseite (14, 24), die der Hauptinnenseite gegenüberliegt, aufweist, und dadurch, dass für jedes des ersten und zweiten Blatts (1, 2) der Abschnitt der Innenseite (13, 23), der vom ersten Schenkel (11, 21) begrenzt ist, dem Abschnitt der Innenseite (13, 23) gegenüberliegt, der vom zweiten Blatt (12, 22) begrenzt ist, wobei die Abschnitte der Außenseiten, die von den ersten Schenkeln begrenzt sind, über der gesamten oder einem Teilbereich ihrer Fläche fest miteinander verbunden sind.

4. Vorrichtung nach einem der Ansprüche 1 bis 3, **dadurch gekennzeichnet, dass** für jedes des ersten und zweiten Blatts (1, 2) die Querabmessung des ersten Schenkels (11, 21) von jener des zweiten Schenkels (21, 22) verschieden ist.

5. Vorrichtung nach einem der Ansprüche 1 bis 3, **dadurch gekennzeichnet, dass** die gegenseitige Blockierung der ersten Schenkel (11, 21) durch eine Verschachtelung der gesamten oder eines Teilbereichs der ersten Schenkel miteinander sichergestellt ist.

6. Vorrichtung nach Anspruch 5, **dadurch gekennzeichnet, dass** jeder der ersten Schenkel von einem mittleren Abschnitt (110, 210), der einen proximalen Abschnitt (111, 211) und einen distalen Abschnitt (112, 212) verbindet, gebildet ist, wobei der mittlere Abschnitt Querabmessungen aufweist, die kleiner als jene des distalen und proximalen Abschnitts sind, wobei die Außenseiten, die von den proximalen Abschnitten begrenzt sind, gegenüberliegen, und die Innenflächen der distalen Abschnitte gegenüberliegen.

7. Vorrichtung nach Anspruch 5, **dadurch gekennzeichnet, dass** jeder der ersten Schenkel von einem mittleren Abschnitt (110, 210), der einen proximalen Abschnitt (111, 211) und einen distalen Abschnitt (112, 212) verbindet, gebildet ist, wobei der mittlere Abschnitt eine Querabmessung aufweist, die im Wesentlichen identisch mit jenen des distalen und proximalen Abschnitts ist, wobei die Außenseiten, die von den proximalen und distalen Abschnitten begrenzt sind, gegenüberliegen, und die Innenflächen, die von den mittleren Abschnitten begrenzt sind, gegenüberliegen.

8. Vorrichtung nach einem der Ansprüche 1 bis 6, **dadurch gekennzeichnet, dass** jeder der zweiten Schenkel mindestens einen Vorsprung (71, 72, 73, 74, 75, 76, 770, 771, 781) aufweist, der geeignet ist, zur Anwendung einer mechanischen Beanspruchung auf die Blätter mit einem äußeren Mechanismus zusammenzuwirken.

## Claims

1. Piezoelectric device for generating electrical voltage comprising at least one first blade (1) having a curved portion (10) delimiting a first branch (11) and a second branch (12) of the blade, the first branch (11) being intended to be secured to a fixed support, the second branch (12) being substantially planar and having a free end (120) that can oscillate about its rest position under the effect of a mechanical force, at least one piezoelectric element (31) resting on one of the main faces (14) of the second branch (12) of the first blade, and comprising a second blade (2) of a structure identical to the first blade (1), all or part of the surface of one of the main faces of the first branch (11) of the first blade (1) being secured to all or part of the surface of one of the main faces of the first branch (21) of the second blade (2), and the first branches being fixed with respect to one another, **characterized in that** the first branches (11, 21) are in direct contact and **in that** each of the first branches (11, 21) has at least one opening (40, 41, 42, 43) that can at least cooperate with means for fixing the first branches (11, 21) to the fixed support.

2. Device according to Claim 1, ***characterized* in that** each of the first and second blades (1, 2) has an inner main face (13, 23) and an outer main face (14, 24) opposite said inner main face, the inner main faces of the first branches (11, 21) of the first blade (1) and of the second blade (2) facing one another, and being secured to one another over all or part of their surface.

3. Device according to Claim 1, ***characterized* in that** each of the first and second blades (1, 2) has an inner main face (13, 23) and an outer main face (14, 24) opposite said inner main face, and **in that**, for each of the first and second blades (1, 2), the portion of the inner face (13, 23) delimited by the first branch (11, 21) is facing the portion of the inner face (13, 23) delimited by the second branch (12, 22), the portions of the outer faces delimited by the first branches being secured to one another over all or part of their surface.

4. Device according to one of Claims 1 to 3, ***characterized* in that**, for each of the first and second blades (1, 2), the transverse dimension of the first branch (11, 21) is different from that of the second branch (21, 22).

5. Device according to one of Claims 1 to 3, ***characterized* in that** the mutual immobilizing of the first branches (11, 21) is ensured by a mutual interweaving of all or part of the first branches.

6. Device according to Claim 5, ***characterized* in that** each of the first branches is formed by a central part (110, 210) linking a proximal part (111, 211) and a distal part (112, 212), the central part having transverse dimensions smaller than those of the distal and proximal parts, the outer faces delimited by the proximal parts being opposite and the inner faces of the distal parts being opposite.

7. Device according to Claim 5, ***characterized* in that** each of the first branches is formed by a central part (110, 210) linking a proximal part (111, 211) and a distal part (112, 212), the central part being of a transverse dimension substantially identical to those of the distal and proximal parts, the outer faces delimited by the proximal and distal parts being opposite, and the inner faces delimited by the central parts being opposite.

8. Device according to one of Claims 1 to 6, ***characterized* in that** each of the second branches has at least one protuberance (71, 72, 73, 74, 75, 76, 770, 771, 781) that can cooperate with an external mechanism for the application of a mechanical strain on the blades.
